# EUROPEAN PATENT APPLICATION

(11) **EP 3 564 969 A1**
(43) Date of publication of application: **06.11.2019**
(21) Application number: 17886598.6
(22) Date of filing: 28.12.2017
(51) Int. Cl.: H01B 1/22, B22F 1/00, B22F 1/02, H01B 1/00

(54) **BONDING MATERIAL, AND BONDING METHOD USING SAME**

(30) Priority: 28.12.2016 JP 2016256400; 27.12.2017 JP 2017251767
(71) Applicant: DOWA ELECTRONICS MATERIALS CO., LTD., Chiyoda-ku Tokyo 101-0021 (JP)
(72) Inventor: FUJIMOTO Hideyuki, Tokyo 101-0021 (JP); ENDOH Keiichi, Tokyo 101-0021 (JP); HORI Tatsuro, Tokyo 101-0021 (JP); KURITA Satoru, Tokyo 101-0021 (JP)
(74) Representative: Müller-Boré & Partner Patentanwälte PartG mbB
(86) International application number: PCT/JP2017/047171
(87) International publication number: WO 2018/124263

(57) **Abstract**

The present invention aims at providing a bonding material having both preferable dispensing properties and preferable bonding properties, and also providing a bonding method employing the bonding material. Provided are: a bonding material comprising fine silver particles having an average primary particle diameter of smaller than or equal to 130 nm, and a crosslinking-type inter-particle distance keeping agent crosslinking between the fine silver particles and keeping a distance between the fine silver particles; and a bonding method employing the bonding material.

## Description

### Technical Field

The present invention relates to a bonding material and a bonding method employing same, in particular to a bonding material containing fine silver particles and a bonding method employing this bonding material.

### Background Art

Metal, when having a size of a minute particle diameter, is known to demonstrate physical properties that are peculiar to the size. Nano-order particles in particular may demonstrate different properties from those of a bulk material. Based on such characteristics, there are proposed bonding materials in which nanometal particles are used to bond different substances.

To cite an example, Patent Document 1, which aims at ensuring adequate bonding strength with the simplest possible constitution while also limiting unevenness in bonding strength, discloses a bonding material that contains: fine silver particles having an average primary particle diameter (D50 diameter) of 0.5 to 3.0 µm (as measured with the particle size distribution measurement device "Microtrac"); fine silver particles having an average primary particle diameter of 1 to 200 nm (as measured with "Microtrac") and being coated with a fatty acid having a carbon number of 6; and a disperse medium for dispersing the fine silver particles.

Further, Patent Document 2, which aims at enabling uniform application on a bonding surface even with an increased silver content and forming a dense bonding layer to achieve resistance to repeated heat shock, discloses a bonding material constituted by: fine silver particles being coated with a carboxylic acid that has a carbon number of lower than or equal to 6 and having an average primary particle diameter of 10 to 30 nm; fine silver particles being coated with a carboxylic acid that has a carbon number of lower than or equal to 6 and having an average primary particle diameter of 100 to 200 nm; fine silver particles having an average primary particle diameter of 0.3 to 3.0 µm; and a dispersing agent having a phosphoric ester group.

### Citation List

### Patent Literature

Patent Document 1: Japanese Patent No. 5824201
Patent Document 2: Japanese Patent No. 5976684

### Summary of Invention

### Technical Problem

The inventors of the present invention continued intensive studies on conventional bonding materials, which are represented by the patent documents above, and as a result, found out that when bonding materials containing fine silver particles are used, if dispense-type printing is adopted, notable amount of fluctuation occurs in the amount of bonding material being discharged through a nozzle. Hereinbelow, such fluctuation in the bonding material discharged amount will be referred to as "dispensing properties" and the dispensing properties will be described as being preferable when the fluctuation in the discharged amount is small. Further, in this description, a printing method in which printing is performed by applying shear force on a bonding material (ink or paste) so as to discharge the bonding material from a nozzle will be referred to as "dispense-type printing".

As set forth in the patent documents above, it is known to use both minute, nano-sized fine silver particles and micron-sized silver particles in combination in a bonding material. In these documents, bonding properties are evaluated in terms of bonding strength; however, a bonding material is required not only to bond substances to be bonded with adequate strength but also to ensure electrical continuity therebetween. If there are voids or cracks when a bonding layer is formed by sintering a bonding material, although a certain level of bonding strength may still be obtained, it is conceivable that electrical continuity may be inadequate, and it is also conceivable that such voids or cracks may become the cause of a crack occurring in the process of processing a product. The inventors of the present invention considered that, in order to comprehensively evaluate the aforementioned matters, it would be appropriate to evaluate whether voids or cracks are present in a bonding layer. In this description, a condition in which there are few or no voids or cracks in a bonding layer will be expressed as the bonding properties being preferable.

Studies conducted by the inventors of the present invention have revealed that the minute, nano-sized fine silver particles mentioned above are effective for making the bonding properties preferable, but lead to degradation in dispensing properties. It was also revealed that in order to improve on the dispensing properties, it is effective to increase the proportion of the fine silver particles that are described in the patent documents above as having a relatively large particle size or to increase the particle size itself. It was found, however, that since such use of larger particles lead to a reduction in the proportion of the minute fine silver particles, the bonding properties of the formed bonding layer are degraded.

In view of the above, the present invention aims at providing a bonding material having both preferable dispensing properties and preferable bonding properties, which are in a trade-off relationship as described above, as well as providing a bonding method employing the bonding material.

### Solution to Problem

As a result of conducting intensive studies in order to solve the problems described above, the inventors of the present invention discovered that if a substance having a function to keep the distances between fine silver particles appropriate is added to the bonding material, both dispensing properties and bonding properties can be obtained, and thus achieved the present invention.

A first aspect of the present invention is
a bonding material comprising
fine silver particles having an average primary particle diameter of smaller than or equal to 130 nm, and
a crosslinking-type inter-particle distance keeping agent crosslinking between the fine silver particles and keeping a distance between the fine silver particles.

A second aspect of the present invention is the invention as set forth in the first aspect, wherein
the crosslinking-type inter-particle distance keeping agent is a compound α expressed by formula (I) below 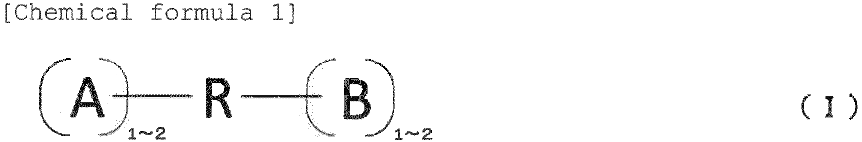 (here, in formula (I), R represents an organic group having a valence of 2 to 4,
A and B represent a hydroxyl group, amino group, carboxyl group, or thiol group, and in a case where two As are present, the two As may be identical or different from each other and in a case where two Bs are present, the two Bs may be identical or different from each other, and
assuming that in the longest straight-chain moiety forming R, the longest moiety from among moieties between an atom 1 bonding to A and an atom 2 bonding to B is a first main chain, the number of chain-forming atoms of the first main chain is 10 to 180).

A third aspect of the present invention is the invention as set forth in the second aspect, wherein
at least one from among A and B in the formula (I) is a hydroxyl group, amino group, or thiol group, and
the longest straight-chain moiety forming R in the formula (I) has a side chain, and the number of chain-forming atoms of the longest straight-chain moiety in the side chain is smaller than or equal to 1/3 of the number of chain-forming atoms of the first main chain.

A fourth aspect of the present invention is the invention as set forth in the second or third aspect, wherein
the longest straight-chain moiety forming R in the formula (I) has a side chain, the side chain is a hydrocarbon group having a carbon number of 1 to 12, and A and B may bond to the side chain.

A fifth aspect of the present invention is the invention as set forth in any one of the second to fourth aspects, wherein
assuming that in the formula (I), the longest straight-chain moiety forming the compound α is a second main chain, chain-forming atoms (excluding atoms at a chain terminal) of the first main chain and the second main chain form a group selected from -CH₂-, -CH(R^{a})-, -C(R^{a})₂-, -CX₂-, -CX(R^{a})-, - CH=, -C(R^{a})=, =C=, -CO-, -NH-, -N(R^{a})-, -N=, -N(OH)-, -O-, - S-, and -SO₂- (here, R^{a} represents a side chain of the longest straight-chain moiety forming R, and X represents halogen).

A sixth aspect of the present invention is the invention as set forth in the second aspect, wherein
the compound α is any one of formulae (II) to (IV) below 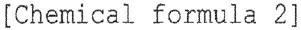 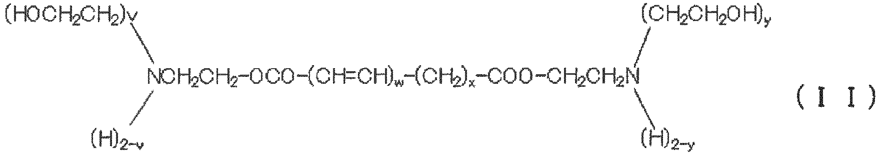 (here, in formula (II), v and y are each independently an integer of 1 to 2, w is an integer of 0 to 10, and x is an integer of 14 to 40) 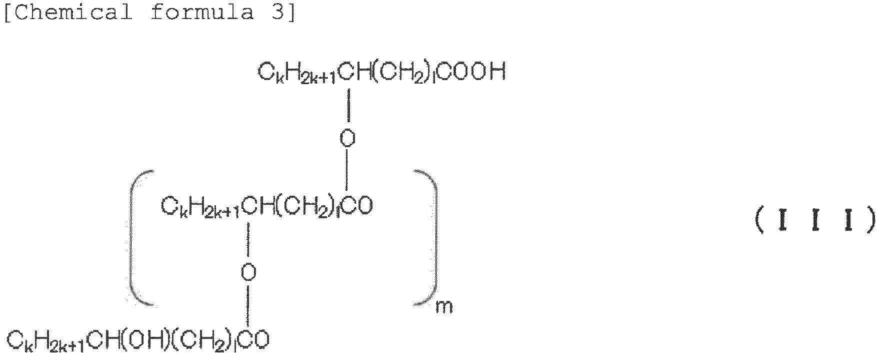 (here, in formula (III), the plurality of ks are each independently an integer of 3 to 10, the plurality of ls are each independently an integer of 6 to 16, and m is an integer of 2 to 8)
[Chemical formula 4]

CₙH₂ₙ₊₁CHOH)-(CH₂)ₚ-CONH-(CH₂)_{q}-NHCO-(CH₂)ᵣ-CH(OH)CₛH₂ₛ₊₁ (IV)

(here, in formula (IV), n and s are each independently an integer of 3 to 10, p and r are each independently an integer of 6 to 18, and q is an integer of 2 to 10).

A seventh aspect of the present invention is the invention as set forth in any one of the first to sixth aspects, wherein
the bonding material further comprises silver particles having an average primary particle diameter of 0.3 to 10 µm.

An eighth aspect of the present invention is the invention as set forth in any one of the first to seventh aspects, wherein
the fine silver particles are coated with an organic compound.

A ninth aspect of the present invention is the invention as set forth in any one of the first to eighth aspects, wherein
the bonding material further comprises a polar solvent.

A tenth aspect of the present invention is the invention as set forth in any one of the first to ninth aspects, wherein
the bonding material further comprises an acid-type dispersing agent.

An eleventh aspect of the present invention is a bonding method comprising:
placing the bonding material as set forth in any one of the first to tenth aspects between substances to be bonded and heating the bonding material to form a bonding layer from the bonding material; and bonding together the substances accordingly.

### Advantageous Effects of Invention

According to the present invention, a bonding material having both preferable dispensing properties and preferable bonding properties and a bonding method employing the bonding material can be provided.

### Brief Description of Drawings

Fig. 1 is a set of photographs showing results of observation with C-SAM of a bonded body obtained using a bonding material, where (a) shows a result relating to Example 1 and (b) shows a result relating to Comparative example 1.
Fig. 2 is a plot showing a result relating to a change over time of viscosity when a shear strength (shear rate: 1/s) was changed for the bonding material according to Example 1, where the horizontal axis indicates time (s) and the vertical axis indicates viscosity (Pa·s).
Fig. 3 is a plot showing a result relating to a change over time of a recovery rate of viscosity obtained on the basis of Fig. 2, where the horizontal axis indicates time (s) and the vertical axis indicates the recovery rate.
Fig. 4 is a plot showing a result relating to a change over time of viscosity when a shear strength (shear rate: 1/s) was changed for a bonding material according to Comparative example 2, where the horizontal axis indicates time (s) and the vertical axis indicates viscosity (Pa·s).
Fig. 5 is a plot showing a result relating to a change over time of a recovery rate of viscosity obtained on the basis of Fig. 4, where the horizontal axis indicates time (s) and the vertical axis indicates the recovery rate.
Fig. 6 is a plot showing a result relating to a change over time of viscosity when a shear strength (shear rate: 1/s) was changed for a bonding material according to Example 4, where the horizontal axis indicates time (s) and the vertical axis indicates viscosity (Pa·s).
Fig. 7 is a plot showing a result relating to a change over time of a recovery rate of viscosity obtained on the basis of Fig. 6, where the horizontal axis indicates time (s) and the vertical axis indicates the recovery rate.
Fig. 8 is a plot showing a result relating to a change over time of viscosity when a shear strength (shear rate: 1/s) was changed for a bonding material according to Example 5, where the horizontal axis indicates time (s) and the vertical axis indicates viscosity (Pa·s).
Fig. 9 is a plot showing a result relating to a change over time of a recovery rate of viscosity obtained on the basis of Fig. 8, where the horizontal axis indicates time (s) and the vertical axis indicates the recovery rate.
Fig. 10 is a plot showing a result relating to a change over time of viscosity when a shear strength (shear rate: 1/s) was changed for a bonding material according to Example 6, where the horizontal axis indicates time (s) and the vertical axis indicates viscosity (Pa·s).
Fig. 11 is a plot showing a result relating to a change over time of a recovery rate of viscosity obtained on the basis of Fig. 10, where the horizontal axis indicates time (s) and the vertical axis indicates the recovery rate.
Fig. 12 is a plot showing a result relating to a change over time of viscosity when a shear strength (shear rate: 1/s) was changed for a bonding material according to Example 7, where the horizontal axis indicates time (s) and the vertical axis indicates viscosity (Pa·s).
Fig. 13 is a plot showing a result relating to a change over time of a recovery rate of viscosity obtained on the basis of Fig. 12, where the horizontal axis indicates time (s) and the vertical axis indicates the recovery rate.

### Description of Embodiments

The present invention will be described in detail below. Note: In this description, a range indicated by two boundary values connected with the term "to" is inclusive of the boundary values.

In this embodiment, description will be given in the following order.
1 Bonding Material
   1-1 Fine Silver Particles
   1-2 Silver Particles
   1-3 Crosslinking-type inter-particle distance keeping agent
   1-4 Solvent
   1-5 Dispersing Agent
   1-6 Others
   1-7 Bonding Material Production Method
2 Bonding Method employing Bonding Material

### 1 Bonding Material

Elements constituting a bonding material according to this embodiment will be described (the bonding material being a silver paste containing fine silver particles).

### 1-1 Fine Silver Particles

There are no particular limitations on the fine silver particles to be used in this embodiment, given that the average primary particle diameter thereof is smaller than or equal to 130 nm. A method known in the art may be used as a method for producing the fine silver particles, and it is also possible to use fine silver particles that are known in the art and have an average primary particle diameter of smaller than or equal to 130 nm.

Fine silver particles having an average primary particle diameter of smaller than or equal to 130 nm are preferable in terms of bonding properties and, in particular, fine silver particles having an average primary particle diameter of 1 to 40 nm superior in bonding properties. From the viewpoint of bonding properties, the average primary particle diameter of the fine silver particles is more preferably 5 to 30 nm, yet more preferably 10 to 20 nm.

Although not as much as 40 nm or smaller fine silver particles, fine silver particles having an average primary particle diameter of greater than or equal to 41 nm are also preferable in terms of bonding properties and, at the same time, allow for a reduction in the viscosity of the bonding material (compared to when 40 nm or smaller fine silver particles are added) so that the bonding material can be printed more readily. From the viewpoint of balance between such bonding properties and printing suitability, the average primary particle diameter of the fine silver particles is preferably 50 to 115 nm, more preferably 55 to 100 nm.

In this embodiment, taking bonding properties and printing suitability into account, there may be used as the fine silver particles a combination of fine silver particles having an average primary particle diameter of 1 to 40 nm and fine silver particles having an average primary particle diameter of 41 to 130 nm.

An average primary particle diameter of metal particles (fine silver particles or silver particles (to be described later)) as referred to in this description means an average value of primary particle diameters obtained on the basis of a transmission electron microscopic photograph (TEM image) or scanning electron microscopic photograph (SEM image) of the metal particles.

More specifically, such an average primary particle diameter may be calculated from the primary particle diameters of any 100 or more metal particles in an image (scanning electron microscope (SEM) image or transmission electron microscope (TEM) image) (the diameters being diameters of circles having the same areas as the metal particles) that is obtained through observation of the metal particles at a prescribed magnification using, for example, a TEM (JEM-1011 (Japan Electron Optics Laboratory Ltd.)) or a SEM (S-4700 (Hitachi Hi-Technologies Corporation)). Image analysis software (EIZOU KUN (registered trademark) (Asahi Kasei Engineering Corporation)), for example, may be used for such a calculation of an average primary particle diameter of metal particles.

The fine silver particles used in the present invention are prone to aggregation because of the average primary particle diameter thereof being as small as smaller than or equal to 130 nm, so it is preferable that the particles be coated with an organic compound. For such an organic compound, any known organic compound that is able to coat fine silver particles can be used. A saturated fatty acid, an unsaturated fatty acid, or an amine having a carbon number of smaller than or equal to 8, preferably 2 to 6, is preferable as the organic compound so that through low-temperature (e.g., 170°C to 400°C) sintering, the organic compound separates from the fine silver particles adequately and does not hinder sintering of the fine silver particles. Examples of such saturated fatty acid or amine include hexanoic acid, sorbic acid, hexylamine, and octylamine.

The content of the fine silver particles described above in the bonding material according to this embodiment is preferably 4% to 97% by mass, more preferably 4% to 85% by mass, from the viewpoint of demonstrating appropriate bonding strength.

### 1-2 Silver Particles

Silver particles having an average primary particle diameter of 0.3 to 10 µm may be added to the bonding material according to this embodiment. Addition of silver particles allows for a reduction in the viscosity of the bonding material and facilitates printing of the bonding material (compared to when the metal particles are constituted solely by fine silver particles without the addition of silver particles). From the viewpoint of such printing suitability, the average primary particle diameter of the silver particles is more preferably 0.3 to 5 µm, yet more preferably 0.3 to 3 µm.

The silver particles may be coated with an organic compound for purposes such as attaining higher dispersibility, and when doing so, it is preferable that an organic compound having a carbon number of smaller than or equal to 20 (the carbon number of an organic compound is usually greater than or equal to 2) be used to coat the silver particles.

The content of silver particles in the bonding material according to this embodiment is preferably 20% to 80% by mass from the viewpoint of ensuring good printing suitability without degradation in bonding properties due to a reduction in the amount of fine silver particles blended.

When silver particles are to be used, then the total content of fine silver particles and silver particles in the bonding material according to this embodiment is preferably 85% to 97% by mass, more preferably 87% to 95% by mass, from the viewpoint of what has been described above.

### 1-3 Crosslinking-type Inter-Particle Distance Keeping Agent

The bonding material according to this embodiment contains a crosslinking-type inter-particle distance keeping agent that keeps a distance between fine silver particles through crosslinking between fine silver particles. Crosslinking between fine silver particles allows a physical distance to be kept between the fine silver particles so that aggregation of the fine silver particles prior to use of the bonding material can be prevented and a dispersed state of the fine silver particles can be maintained. At the same time, with this crosslinking, the cross-link breaks or weakens due to application of shear force, resulting in a decrease in viscosity so that discharge in dispense-type printing is facilitated, whereas when the printing has been completed and there is no shear force, viscosity is recovered even in an ink having ordinary thixotropy, and it is considered that the recovery of the cross-link results in an earlier recovery of the viscosity (see the examples described later). In this way, the crosslinking-type inter-particle distance keeping agent is found to make the dispensing properties of the bonding material preferable.

Moreover, the crosslinking-type inter-particle distance keeping agent during sintering (being heated to, for example, 170°C to 400°C) volatilize due to being heated or at least the molecular motion thereof becomes more active due to being heated, thereby becoming more easily separable from the fine silver particle, so the crosslinking-type inter-particle distance keeping agent does not hinder sintering of the fine silver particles, and thus preferable bonding properties can be achieved. Note that if metal particles other than fine silver particles are present in the bonding material, the crosslinking-type inter-particle distance keeping agent may crosslink between such metal particles or between such metal particles and fine silver particles.

Any agent, without particular limitations, can be used for the crosslinking-type inter-particle distance keeping agent as long as the agent demonstrates a similar function to the aforementioned by cross-linking (bonding) between fine silver particles. To cite an example of such cross-link, a bond to silver per se may serve to bond fine silver particles together through the crosslinking-type inter-particle distance keeping agent.

The crosslinking-type inter-particle distance keeping agent has a plurality of functional groups (e.g., a hydroxyl group, amino group, thiol group, and carboxyl group) that have affinity for the fine silver particles so as to crosslink between the fine silver particles. Although the crosslinking-type inter-particle distance keeping agent serves to keep a distance between fine silver particles, if the distance is too long, a gap will be present between the fine silver particles, which may result in the formation of voids during sintering for the bonding and thus cause cracks and the like; therefore, it is preferred that the crosslinking-type inter-particle distance keeping agent have a molecular length and a molecular structure according to which a distance that is appropriate from the aforementioned perspective can be kept between fine silver particles.

As a result of using such a crosslinking-type inter-particle distance keeping agent, it is possible to achieve both preferable dispensing properties and bonding properties in the bonding material including the fine silver particles.

The crosslinking-type inter-particle distance keeping agent may be, for example, a compound α expressed by formula (I) below.

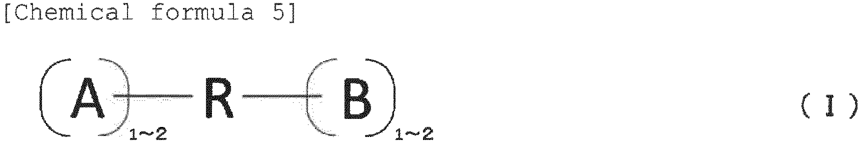

In the formula (I), R represents an organic group having a valence of 2 to 4, A and B represent a hydroxyl group, amino group, carboxyl group, or thiol group, and assuming that in the longest straight-chain moiety forming R, the longest moiety from among moieties between an atom 1 bonding to A and an atom 2 bonding to B is a first main chain, the number of chain-forming atoms of the first main chain is 10 to 180. In a case where two As are present, the two As may be identical or different from each other; the same stands for B. Moreover, A and B may bond to any site in the longest straight-chain moiety of R and may not bond to a terminal of the straight-chain moiety.

Here, R may have a side chain. A and B may bond to this side chain.

The definition of the first main chain is that in a case where there are a plurality of As and/or Bs, observation is made for the first main chain from the side of As and/or Bs that is closest to the molecular terminal.

As a result of the number of the chain-forming atoms of the first main chain being 10 to 180, A and B are separated to a certain degree, and the function of the crosslinking-type inter-particle distance keeping agent of keeping an appropriate distance between the fine silver particles is demonstrated preferably. From the viewpoint of this function, the number of chain-forming atoms of the first main chain is preferably 20 to 120.

Note that for the first main chain, according to the stipulation "the longest moiety from among moieties between an atom 1 bonding to A and an atom 2 bonding to B", the side chain in the first main chain is not included in the count of the number of chain-forming atoms.

The chain-forming atom is an atom that has a valence of greater than or equal to 2 and that bonds to more than or equal to 2 atoms having a valance of greater than or equal to 2. It is assumed that this chain-forming atom includes divalent atoms (e.g., O, N, C, and S) that form A and B. An increase in the number of chain-forming atoms is assumed to indicate a longer chain.

It is preferable that at least one from among A and B in the formula (I) be a hydroxyl group, amino group, or thiol group, the longest straight-chain moiety forming R in the formula (I) have a side chain, and the number of chain-forming atoms of the longest straight-chain moiety in the side chain be smaller than or equal to 1/3 of the number of chain-forming atoms of the first main chain. If so, in the recovery of the viscosity of the bonding material indicated in the examples described later, the original viscosity of the bonding material can be recovered within a short period of time after start of the recovery. Further, it is preferable that the number of chain-forming atoms of the longest straight-chain moiety in the side chain at this time be greater than or equal to 1/100 of the number of chain-forming atoms of the first main chain. It is assumed that the chain-forming atoms of the longest straight-chain moiety in the side chain are equivalent to the chain-forming atoms in the first main chain and include an atom having a valence of greater than or equal to 2 and bonding to H at the side chain terminal.

In the above example, it is particularly preferable that all of A and B be hydroxyl groups, amino groups, or thiol groups from the viewpoint of early recovery of the viscosity of the bonding material and the viewpoint of the bonding properties thereof, and from these viewpoints, it is most preferable that all of A and B be hydroxyl groups.

In a case where the longest straight-chain moiety forming R in the formula (I) has a side chain, examples of the side chain include a hydrocarbon group having a carbon number of 1 to 12 (preferably 2 to 8). This hydrocarbon group may be saturated or unsaturated and may have a branch.

Assuming that in the formula (I), the longest straight-chain moiety forming the compound α is a second main chain, it is preferable that the difference between the numbers of chain-forming atoms of the second main chain and the first main chain be smaller than or equal to 1/4 of the number of chain-forming atoms of the second main chain. If so, A and B are at the molecular terminal of the compound α (i.e. the difference is zero) or in the vicinity thereof, and act more readily with the fine silver particles. Note that while the second main chain indicates the longest straight-chain moiety in the "compound α" itself, the first main chain indicates, as has already been described above, the longest moiety from among moieties between an atom 1 bonding to A and an atom 2 bonding to B in the longest straight-chain moiety forming "R".

The chain-forming atom of the first main chain and the second main chain is preferably C, N, O, or S, more preferably C, N, or O. Preferably, the first main chain and the second main chain are saturated or unsaturated.

To describe more specific examples of the first main chain and the second main chain, the first main chain and the second main chain may be such that the chain-forming atoms thereof form a group selected from -CH₂-, -CH(R^{a})-, - C(R^{a})₂- -CX₂-, -CX(R^{a})-, -CH=, -C(R^{a})=, =C=, -CO-, -NH-, - N(R^{a})-, -N=, -N(OH)-, -O-, -S-, and -SO₂-. Here, R^{a} represents the aforementioned side chain of R, and X represents halogen. Among these, from the viewpoint of the function of the crosslinking-type inter-particle distance keeping agent, preferable is a group selected from -CH₂-, - CH(R^{a})-, -C(R^{a})₂-, -CH=, -C(R^{a})=, -CO-, -NH-, -N(R^{a})-, and - O-.

Specific examples of the compound α expressed by the formula (I) that are particularly preferable will be listed below.

The compound α is preferably a compound expressed by any one of formulae (II) to (IV) below.

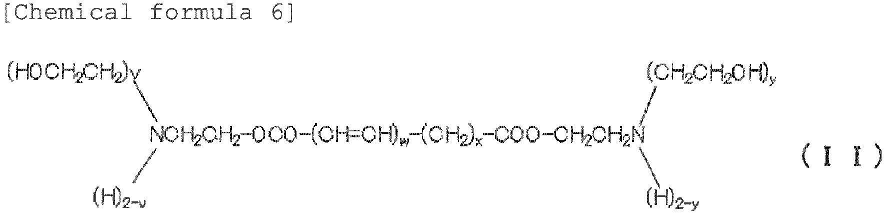

Here, in formula (II), v and y are each independently an integer of 1 to 2, w is an integer of 0 to 10 (preferably an integer of 0 to 8 from the viewpoint of achieving both dispensing properties and bonding properties), and x is an integer of 14 to 40 (preferably an integer of 18 to 36 from the viewpoint of achieving both dispensing properties and bonding properties). -(CH=CH)w-(CH₂)x- may have a block structure in which w (CH=CH)s bond contiguously and then x (CH₂)s bond contiguously, or may have a random structure in which these are arranged randomly.

An example of a specific product name of the compound of formula (II) is BYK-R606 (BYK Japan KK).

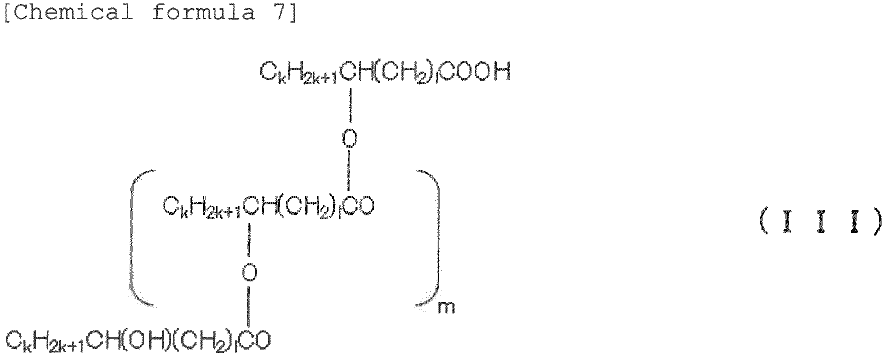

Here, in formula (III), the plurality of ks are each independently an integer of 3 to 10 (preferably an integer of 4 to 8 from the viewpoint of achieving both dispensing properties and bonding properties), the plurality of ls are each independently an integer of 6 to 16 (preferably an integer of 8 to 12 from the viewpoint of achieving both dispensing properties and bonding properties), and m is an integer of 2 to 8 (preferably an integer of 3 to 6 from the viewpoint of achieving both dispensing properties and bonding properties).

An example of a specific product name of formula (III) is HINOACT KF-1000 (Kawaken Fine Chemicals Co., Ltd.).
[Chemical formula 8]

CₙH₂ₙ₊₁CH(OH)-(CH₂)ₚ-CONH-(CH₂)_{q}-NHCO-(CH₂)ᵣ₋CH(OH)CₛH₂ₛ₊₁ (IV)

Here, in formula (IV), n and s are each independently an integer of 3 to 10 (preferably an integer of 4 to 8 from the viewpoint of achieving both dispensing properties and bonding properties), p and r are each independently an integer of 6 to 18 (preferably an integer of 8 to 14 from the viewpoint of achieving both dispensing properties and bonding properties), and q is an integer of 2 to 10 (preferably an integer of 2 to 6 from the viewpoint of achieving both dispensing properties and bonding properties).

An example of a specific product name of the compound of formula (IV) is MA-WAX-O (KF TRADING CO., LTD.).

From among the compounds of formulae (II) to (IV) described above, the compound expressed by formula (II) is particularly preferable from the viewpoint of bonding properties and dispensing properties.

Other preferable examples of the compound α include polyhydroxycarboxylic acid ester (synthesized from transesterification of dicarboxylic acid dimethyl ester with alkanolamines) (the polyhydroxycarboxylic acid ester including BYK-R606 (BYK Japan KK) mentioned above).

While not as preferable as the compounds of formulae (II) to (IV) above for the compound α, used as other examples of the compound α may be hydrogenated castor oils (e.g. that produced by KF TRADING CO., LTD.) or a dimer acid (a liquid fatty acid, the main component of which is a dibasic of C36 dicarboxylic acid obtained by dimerization of a vegetable oil-based C18 unsaturated fatty acid and which contains a monobasic and a tribasic (e.g. product name: Tsunodyme 395 (TSUNO CO., LTD.)).

The content of the crosslinking-type inter-particle distance keeping agent described above in the bonding material according to this embodiment is preferably 0.01% to 2% by mass, more preferably 0.03% to 1% by mass, from the viewpoint of achieving both preferable dispensing properties and preferable bonding properties.

### 1-4 Solvent

A bonding material usually contains a solvent so that the bonding material assumes an easily printable form. There are no particular limitations on the solvent to be used in this embodiment, given that, eventually, there can be obtained a bonding material (silver paste) with which a bonding layer can be formed through sintering of fine silver particles (and silver particles) and which has a viscosity such that printing can be performed with ease. One type of solvent may be used singly or two or more types thereof may be used in combination.

The content of the solvent in the bonding material is preferably 1% to 10% by mass, more preferably 2% to 8% by mass. A polar solvent or a non-polar solvent may be used for this solvent, and from the viewpoint of environmental load and miscibility with other components in the bonding material, a polar solvent is preferable. Used as such a polar solvent may be water, alcohol, polyol, glycol ether, 1-methylpyrrolidinone, pyridine, terpineol, butyl carbitol, butyl carbitol acetate, texanol, phenoxypropanol, diethylene glycol monobutyl ether, diethylene glycol monobutyl ether acetate, γ-butyrolactone, ethylene glycol monomethyl ether acetate, ethylene glycol monoethyl ether acetate, methoxybutyl acetate, methoxypropyl acetate, diethylene glycol monoethyl ether acetate, ethyl lactate, 1-octanol, and so on. It is preferable to use, as such a polar solvent, 1-decanol, 1-dodecanol, 1-tetradecanol, 3-methyl-1,3-butanediol 3-hydroxy-3-methylbutyl acetate, 2-ethyl-1,3-hexanediol, hexyl diglycol, 2-ethylhexyl glycol, dibutyl diglycol, glycerin, dihydroxyterpineol, dihydroterpinyl acetate, 2-methyl-butane-2,3,4-triol (isoprene triol A (IPTL-A (Nippon Terpene Chemicals, Inc.))), 2-methyl-butane-1,3,4-triol (isoprene triol B (IPTL-B, Nippon Terpene Chemicals, Inc.))), Terusolve IPG-2Ac (Nippon Terpene Chemicals, Inc.)), Terusolve MTPH (Nippon Terpene Chemicals, Inc.), Terusolve DTO-210 (Nippon Terpene Chemicals, Inc.), Terusolve THA-90 (Nippon Terpene Chemicals, Inc.), Terusolve THA-70 (Nippon Terpene Chemicals, Inc.), Terusolve TOE-100 (Nippon Terpene Chemicals, Inc.), dihydroterpinyloxyethanol (Nippon Terpene Chemicals, Inc.), terpinyl methyl ether (Nippon Terpene Chemicals, Inc.), dihydroterpinyl methyl ether (Nippon Terpene Chemicals, Inc.), and so on, and it is more preferable to use, as such a solar solvent, at least one from among 1-decanol, 1-dodecanol, 2-ethyl-1,3-hexanediol, and 2-methyl-butane-1,3,4-triol (isoprene triol B (IPTL-B)).

### 1-5. Dispersing Agent

In this embodiment, a dispersing agent may be added to the bonding material for the purpose of keeping the dispersed state of the fine silver particles more reliably. Any dispersing agent, with no particular limitations, may be used that can maintain dispersion of the fine silver particles and that, during sintering, separates from the fine silver particles through, for example, volatilization from the particles. For the dispersing agent, various commercially-available dispersing agents may be used, among which use of acid-type dispersing agents and phosphoric ester-type dispersing agents is preferable. Examples of the acid-type dispersing agent include butoxyethoxy acetic acid. One type from among such dispersing agents may be used singly or two or more types therefrom may be used in combination.

The content of the dispersing agent in the bonding material is preferably 0.01% to 3% by mass, more preferably 0.03% to 2% by mass.

### 1-6 Others

Components known in the art may be included, as appropriate, in the bonding material according to this embodiment, in addition to the constituents mentioned above. Specific examples of such components include viscosity modifiers, organic binders, inorganic binders, pH adjusters, buffers, antifoaming agents, leveling agents, and volatilization inhibitors.

A preferable viscosity of the bonding material according to this embodiment is 5 to 40 Pa·s as a general index, although the preferable viscosity varies according to the printing method in question in which the bonding material is adopted. In this description, unless specifically noted otherwise, the viscosity is measured using a rotary dynamic viscoelasticity measurement device under the condition of 25°C and 5 rpm.

### 1-7 Bonding Material Production method

Next, a bonding material production method according to this embodiment will be described. The bonding material may be produced by, for example, separately preparing the components forming the bonding material and mixing the same in an arbitrary order using ultrasonic dispersion, disper, 3-roll mill, ball mill, beads mill, twin-screw kneader, revolving stirrer, or the like.

### 2. Bonding Method Employing Bonding Material

The technical concept of the present invention is applicable to a bonding method that employs the bonding material described above. To cite an example, the technical concept may be applied to a bonding method including: placing the bonding material described above between substances to be bonded and heating the bonding material to form a bonding layer from the bonding material; and bonding together the substances accordingly.

A method known in the art may be used as a specific bonding method, and the following shows some examples.

The bonding material (silver paste) described above may be applied onto at least one of two substances to be bonded by dispense-type printing; the bonding material may be disposed so as to be interposed between the substances; and heating may be carried out at 170°C to 400°C, preferably at 200°C to 300°C, in order to sinter the fine silver particles (and silver particles) in the bonding material, thereby forming a bonding layer, so that the substances are bonded through this bonding layer. Alternatively: the bonding material may be applied to one of two substances to be bonded; heating may be carried out at 60°C to 160°C, preferably 80°C to 150°C, to dry the bonding material and form a pre-dried film; the other one of the substances to be bonded may be placed on the pre-dried film; and thereafter heating may be carried out at 170°C to 400°C, preferably at 200°C to 300°C, in order to sinter the fine silver particles (and silver particles) in the bonding material, thereby forming a bonding layer, so that the substances are bonded through this bonding layer. When carrying out heating, pressure may be applied on the substances to be bonded, although such application of pressure is not essential. The substances to be bonded can be bonded through heating in an inert atmosphere such as nitrogen atmosphere but can also be bonded through heating in the atmosphere.

For the bonding method according to this embodiment, the bonding material according to the present invention has been described as being printed using a dispense-type printing method; however, the bonding material may be printed using other methods such as metal mask printing. Examples of the substances to be bonded in the bonding method include: a substrate and a semiconductor element; a substrate and another substrate (which may be formed from different materials); etc.

The technical scope of the present invention is not limited to the embodiments described above, and encompass embodiments to which a variety of modifications or improvements are made within a scope in which it is possible to derive specific effects that can be obtained from the constituents of the present invention or from the combination of the constituents.

### EXAMPLES

The present invention will be described in further detail below using examples and comparative examples, although the present invention is not limited by the examples and comparative examples.

### Example 1

### Production of First Fine Silver Particles

First, 3400 g of water was poured into a 5 1 reaction vessel. Then, nitrogen was introduced into the water in the reaction vessel through a nozzle provided at the bottom part of the reaction vessel at a flow rate of 3000 ml/min for 600 seconds to remove dissolved oxygen. Next, the temperature of the water in the reaction vessel was adjusted to 60°C, while supplying nitrogen into the reaction vessel through the top part of the reaction vessel at a flow rate of 3000 ml/min so as to create a nitrogen atmosphere inside the reaction vessel and performing stirring using a stirring bar provided in the reaction vessel and equipped with stirring blades.

7 g of ammonia water containing 28% by mass of ammonia was added to the water in the reaction vessel, followed by stirring for 1 minute to create a homogeneous solution. 45.5 g of hexanoic acid (Wako Pure Chemical Corporation) (mole ratio to silver = 1.98), which is a saturated fatty acid, was added to the solution in the reaction vessel as an organic compound (for coating fine silver particles), and stirring was carried out for 4 minutes to dissolve the same. Thereafter, 50% by mass of hydrazine hydrate (Otsuka Chemical Co., Ltd.) was added as a reducing agent in the amount of 23.9 g (mole ratio to silver = 4.82) to create a reducing agent solution.

A silver nitrate aqueous solution obtained by dissolving 33.8 g of silver nitrate crystal (Wako Pure Chemical Corporation) in 180 g of water was prepared as a silver salt aqueous solution, and the temperature of the silver salt aqueous solution was adjusted to 60°C. Then, 0.00008 g of copper nitrate trihydrate (Wako Pure Chemical Corporation) (1 ppm in terms of copper relative to silver) was added to the silver salt aqueous solution. The addition of copper nitrate trihydrate was carried out such that an aqueous solution obtained by diluting an aqueous solution with a comparatively high concentration of copper nitrate trihydrate was added so that an intended copper addition amount would be achieved.

Next, the silver salt aqueous solution described above was added at once to the reducing agent solution described above and mixed, and stirring the mixture, reduction reaction was initiated. Change in color of the slurry as the reaction solution terminated about 10 seconds after initiation of the reduction reaction. The slurry was aged for 10 minutes while being stirred, after which the stirring was stopped and the slurry was subjected to solid-liquid separation based on suction filtration. The solid obtained by the solid-liquid separation was washed with pure water and vacuum-dried at 40°C for 12 hours, thereby obtaining a dry powder of the first fine silver particles (coated with hexanoic acid).

The proportion of silver in the first fine silver particles was calculated to be 97% by mass from the weight after removal of the hexanoic acid through heating. The average primary particle diameter (particle size) of the first fine silver particles was 17 nm, as measured using a transmission electron microscope (TEM).

### Production of Second Fine Silver Particles

Further, 180.0 g of pure water was poured into a 300 ml beaker and 33.6 g of silver nitrate (TOYO KAGAKU, INC.) was added thereto and dissolved to prepare a silver nitrate aqueous solution as a raw material solution.

In addition, 3322.0 g of pure water was poured into a 5 1 beaker, and while the pure water was aerated with nitrogen for 30 minutes to remove dissolved oxygen, the temperature thereof was raised to 40°C. Added to this pure water was 44.8 g of sorbic acid (Wako Pure Chemical Corporation) as an organic compound (for coating the fine silver particles) and then 7.1 g of 28% ammonia water (Wako Pure Chemical Corporation) as a stabilizer.

While stirring the aqueous solution to which the ammonia water had been added, 14.91 g of 80%-pure hydrous hydrazine (Otsuka Chemical Co., Ltd.) was added to the solution as a reducing agent after the lapse of 5 minutes from the time point at which the ammonia water had been added (reaction initiation time point) to prepare a reducing agent-containing aqueous solution as a reducing solution. After the lapse of 9 minutes from the reaction initiation time point, the raw material solution (silver nitrate aqueous solution), the temperature of which had been adjusted to 40°C, was added at once to the reducing solution (reducing agent-containing aqueous solution) to allow reaction therebetween and the resultant was further stirred for 80 minutes, after which the temperature of the same was raised from 40°C to 60°C at the temperature-raising speed of 1°C/min, then the stirring was terminated.

After an aggregate of fine silver particles coated with sorbic acid was formed in this way, the solution containing the aggregate of fine silver particles was filtered using a No. 5C filter paper, and the substance recovered through the filtration was washed with pure water to obtain an aggregate of fine silver particles. This aggregate of fine silver particles was dried in a vacuum drier at 80°C for 12 hours to obtain a dry powder of the aggregate of fine silver particles. The thus obtained dry powder of the aggregate of fine silver particles was subjected to comminution and the size of the secondary aggregate was adjusted; thus, the second fine silver particles were obtained. The average primary particle diameter (particle size) of the second fine silver particles was 85 nm, as measured using a scanning electron microscope (SEM).

### Production of Bonding Material

Next, what are listed below were kneaded and the substance thus obtained through kneading was passed through a 3-roll machine to obtain a bonding material constituted by a silver paste.
- 14.60% by mass of the dry powder of the fine silver particles (coated with hexanoic acid) with a particle size of 17 nm, produced as the first fine silver particles as described above
- 26.94% by mass of the dry powder of the fine silver particles (coated with sorbic acid) with a particle size of 85 nm, produced as the second fine silver particles as described above
- 51.04% by mass of silver particles (AG2-1C (DOWA Electronics Materials Co., Ltd.)) with a particle size of 0.6 µm
- 1.49% by mass of octanediol (2-ethyl-1,3-hexanediol (Wako Pure Chemical Corporation)) as a first solvent
- 0.85% by mass of 1-dodecanol (Tokyo Chemical Industry Co., Ltd.) as a second solvent
- 3.48% by mass of 2-methyl-butane-1,3,4-triol (isoprene triol B (IPTL-B)) (Nippon Terpene Chemicals, Inc.) as a third solvent
- 0.50% by mass of butoxyethoxy acetic acid (BEA) (Tokyo Chemical Industry Co., Ltd.) as the dispersing agent
- 0.99% by mass of another acid-type dispersing agent
- 0.10% by mass of polyhydroxycarboxylic acid ester (BYK-R606 (BYK Japan KK)) as the crosslinking-type inter-particle distance keeping agent

Table 1 below shows the aforementioned constituents and the contents thereof. The constituents and the contents thereof for Examples 2 and 3 and Comparative examples 1 and 2 described below are also shown in Table 1.

**[Table 1]**

| | Example 1 | Example 2 | Example 3 | Comparative example 1 | Comparative example 2 |
|---|---|---|---|---|---|
| First fine silver particles | 14.60 | 14.61 | 14.48 | 14.63 | 14.62 |
| Second fine silver particles | 26.94 | 26.97 | 26.72 | 27.00 | 26.99 |
| Silver particles: AG2-1C | 51.04 | 51.09 | 50.62 | 51.16 | 51.13 |
| First solvent: 2-ethyl-1,3-hexanediol | 1.49 | 1.49 | 1.48 | 1.50 | 1.50 |
| Second solvent: dodecanol | 0.85 | 0.80 | 2.66 | 0.73 | 1.77 |
| Third solvent: IPTL-B | 3.48 | 3.49 | 3.45 | 3.49 | 3.49 |
| Dispersing Agent: butoxyethoxy acetic acid | 0.50 | 0.50 | 0.49 | 0.50 | 0.50 |
| Other acid-type dispersing agent | 0.99 | 1.00 | 0 | 1.00 | 0 |
| Crosslinking-type inter-particle distance keeping agent: BYK-R606 | 0.10 | 0.05 | 0.10 | 0 | 0 |

### Viscosity of Bonding Material

The viscosity of this bonding material (silver paste) at 25°C, as measured with a rheometer (rotary dynamic viscoelasticity measurement device) (HAAKE RheoStress 600 (a cone with a cone diameter of 35 mm and a cone angle of 2° was used) (Thermo Fisher Scientific)), was 24 (Pa·s) at 5 rpm. The viscosity at 1 rpm was 65 (Pa·s).

Table 2 below shows these viscosities. Table 2 also shows viscosities and the evaluation results therefor (will be described in detail below) for Examples 2 and 3 and Comparative examples 1 and 2 described below.

**[Table 2]**

| | | Example 1 | Example 2 | Example 3 | Comparative example 1 | Comparative example 2 |
|---|---|---|---|---|---|---|
| Viscosity | 1 rpm | 65 | 64 | 86.3 | 55 | 56 |
| | 5 rpm | 24 | 24 | 25 | 25 | 25 |
| Dispensing properties | Weight fluctuation (%) | <±10 | <±10 | <±10 | <±10 | >±10% |
| Bonding properties | Void, crack | None | None | None | Crack | None |

### [Example 2]

A bonding material (silver paste) was produced using an equivalent method to Example 1, except that the amount of each constituent blended in the bonding material was changed as in Table 1 above (the amount of each constituent blended is adjusted so that the viscosity would be substantially the same; same below). The measured viscosity of the bonding material at 25°C was 64 (Pa·s) at 1 rpm and 24 (Pa·s) at 5 rpm.

### Example 3

A bonding material (silver paste) was produced using an equivalent method to Example 1, except that the amount of each constituent blended in the bonding material was changed as in Table 1 above. The measured viscosity of the bonding material at 25°C was 86.3 (Pa·s) at 1 rpm and 25 (Pa·s) at 5 rpm.

### [Comparative Example 1]

A bonding material (silver paste) was produced using an equivalent method to Example 1, except that polyhydroxycarboxylic acid ester (BYK-R606 (BYK Japan KK)) as the crosslinking-type inter-particle distance keeping agent in the bonding material was not used and that the amount of each constituent blended was changed as in Table 1 above. The measured viscosity of the bonding material at 25°C was 55 (Pa·s) at 1 rpm and 25 (Pa·s) at 5 rpm.

### [Comparative Example 2]

A bonding material (silver paste) was produced using an equivalent method to Example 1, except that polyhydroxycarboxylic acid ester (BYK-R606 (BYK Japan KK)) as the crosslinking-type inter-particle distance keeping agent in the bonding material was not used, that butoxyethoxy acetic acid (BEA) (Tokyo Chemical Industry Co., Ltd.) was used alone as the dispersing agent, and that the amount of each constituent blended was changed as in Table 1 above. The measured viscosity of the bonding material at 25°C was 56 (Pa·s) at 1 rpm and 25 (Pa·s) at 5 rpm.

### [Evaluation]

### Evaluation of Dispensing Properties

The bonding materials obtained in the Examples and Comparative examples above were used to evaluate the dispensing properties. The following evaluation method was employed to evaluate the dispensing properties.

The bonding material (silver paste) above was loaded into a syringe. A needle (0.58 mm φ) was attached to the syringe and a 23 mm-long line pattern was drawn (printed) using a dispenser (ML-5000XII (Musashi Engineering Inc.)).

As for the procedure, first, the line pattern was singly printed (so-called "purging") on a glass plate. Then, printing was halted for 3 minutes, whereafter 10 line patterns were printed on another glass plate. An interval between printing one line pattern and starting to print the next line pattern was 1 second.

Thereafter, 10 line patterns were printed on yet another glass plate. An interval between printing the last line pattern on the previous glass plate and starting to print the first line pattern on the next glass plate was 2 seconds. In this way, 15 such glass plates on which 10 line patterns were printed were prepared.

For these glass plates on which line patterns were printed, the weight of the 10 patterns on the first glass plate was assumed to be 100%, and in relation to this, the degree of fluctuation in the weight of the 10 patterns in each of the other, second to fifteenth, glass plates was ascertained. The results showed that variations were within ±10% for Examples 1 to 3 and Comparative example 1, whereas for Comparative example 2, weight fluctuation exceeded ±10%.

It should be noted that although the result for Comparative example 1 in terms of dispensing properties was not unfavorable, there would be a significant difference between Example 1 and Comparative example 1 in terms of bonding properties, which constitute the other item of evaluation.

### Evaluation of Bonding Properties

Next, bonding test was conducted. For the substrate, there was used a 10 mm square copper plate on which gold plating had been applied. Onto this copper plate, the bonding material (silver paste) of the examples and comparative examples was applied in the shape of a 3 mm square-equivalent snow star (asterisk) using the dispenser (ML-5000XII), and a onto this, a semiconductor element having been subjected to 3 mm square gold plating was mounted. Thereafter, in a state where no pressure was applied, the temperature of the copper plate, the semiconductor element, and the bonding material therebetween was raised in an inert oven to 210°C at 0.05°C/sec and was maintained thus for 60 minutes to sinter the fine silver particles and silver particles, thereby forming a silver bonding layer. For the bonded body obtained in this way, an image (C-SAM image) obtained using an ultrasonic microscope (C-SAM: D9500 (SONOSCAN, INC.)) was used to observe whether there were voids in the silver bonding layer (within the silver bonding layer and also on the boundary between the silver bonding layer and the substrate and the boundary between the silver bonding layer and the Si chip).

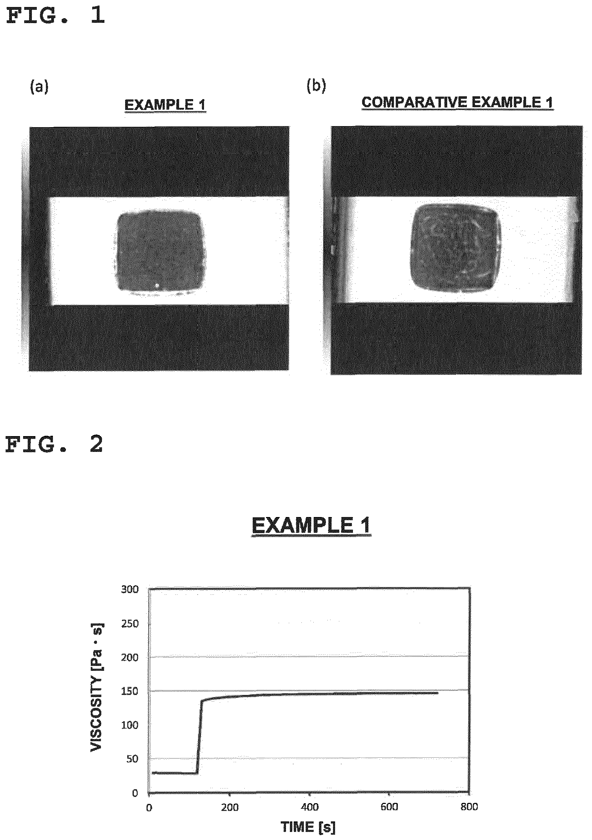

Results for Example 1 and Comparative example 1 are shown in Fig. 1 as representative examples. In Fig. 1, (a) shows an observation result for a silver bonding layer in which the bonding material of Example 1 was used, and (b) shows an observation result for a silver bonding layer in which the bonding material of Comparative example 1 was used.

If the entirety of a C-SAM image was black, there would be no voids, and bonding was assessed as being preferable, whereas if there were white portions in a C-SAM image, there would be voids or cracks, and a bonding state was assessed as not being preferable.

From the results of the evaluation of bonding properties, no cracks or voids were observed and bonding was preferable in the cases in which the bonding materials of Examples 1 to 3 and Comparative example 2 were used. Meanwhile, in the case in which the bonding material of Comparative example 1 was used, there were cracks as shown in Fig. 1 (b) and bonding was not preferable.

According to the above, a bonding material having both preferable dispensing properties and preferable bonding properties, and a bonding method employing the bonding material, could be provided in the case of Examples 1 to 3.

### [Verification of Quick Viscosity Recovery in Examples]

As indicated above, dispensing properties and bonding properties were preferable in the Examples. As a reason for which such results were obtained, a section of the embodiments of the present invention has stated that there is demonstrated an effect that viscosity recovers quickly in the bonding material when shear force ceases to be applied. In this section, how quickly viscosity recovers in relation to the presence or absence of shear force and the progress thereof with time is verified for Example 1 and Comparative example 2 serving as representative examples.

First, the viscosities of the bonding materials produced in Example 1 and Comparative example 2 were measured over time using the aforementioned rheometer (rotary dynamic viscoelasticity measurement device) (HAAKE RheoStress 600 (Thermo Fisher Scientific)). Specifically, the temperature of the bonding material was adjusted to 25°C, and measurement was carried out at the shear rate of 10 (1/s) for 120 seconds, after which the shear rate was reduced to 1 (1/s) and measurement was carried out for 600 seconds. Here, the viscosity at each timepoint after the shear rate was reduced to 1 (1/s) was divided by the viscosity at the timepoint at which measurement was ended (the timepoint at which 600 seconds (during which the reduced shear rate of 1 (1/s) was maintained) elapsed) and the resulting value was defined to be the recovery rate. Figs. 2 to 5 show the results of the same.

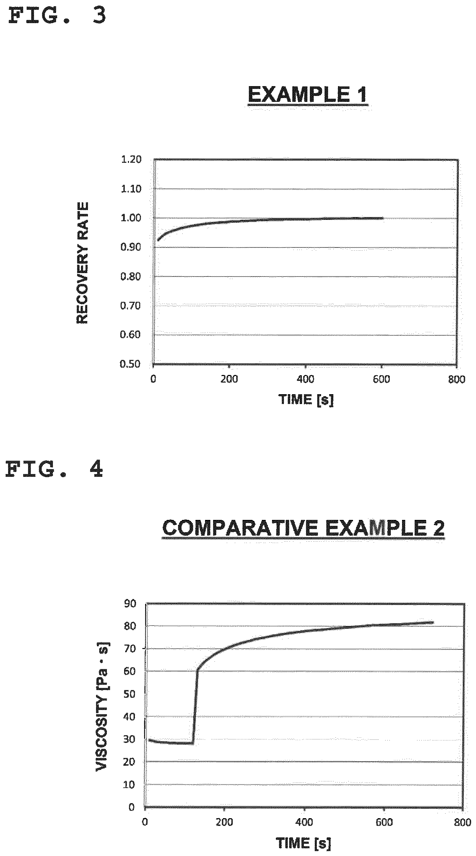

Fig. 2 is a plot showing the result relating to a change over time of viscosity when the shear strength (shear rate: 1/s) was changed for the bonding material according to Example 1, where the horizontal axis indicates time (s) and the vertical axis indicates viscosity (Pa·s). Fig. 3 is a plot showing the result relating to a change over time of the recovery rate obtained on the basis of Fig. 2, where the horizontal axis indicates time (s) and the vertical axis indicates the recovery rate. 0th second in Fig. 3 corresponds to the timepoint of the 120th second in Fig. 2.

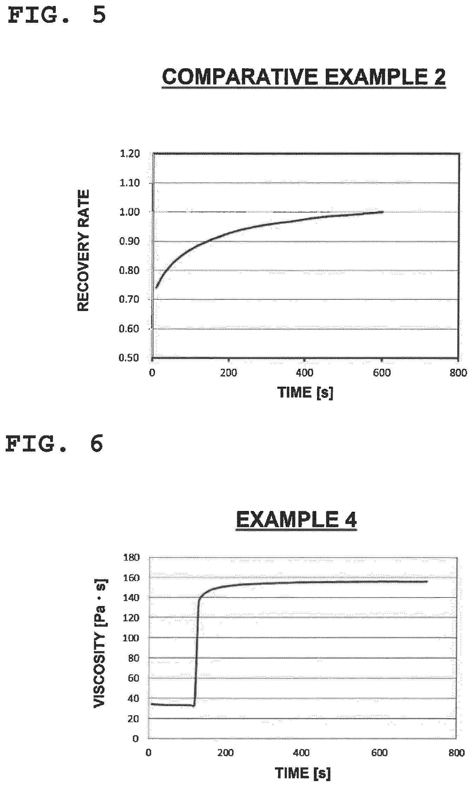

Fig. 4 is a plot showing the result relating to a change over time of viscosity when the shear strength (shear rate: 1/s) was changed for the bonding material according to Comparative example 2, where the horizontal axis indicates time (s) and the vertical axis indicates viscosity (Pa·s). Fig. 5 is a plot showing the result relating to a change over time of the recovery rate obtained on the basis of Fig. 4, where the horizontal axis indicates time (s) and the vertical axis indicates the recovery rate. 0th second in Fig. 5 corresponds to the timepoint of the 120th second in Fig. 4.

In Example 1 (Fig. 2), viscosity recovers very quickly after the shear rate is reduced to 1 (1/s) at once. As an evidence thereof, in Fig. 3, the recovery rate at the measurement starting timepoint is higher than or equal to 0.90.

In contrast, in Comparative example 2 (Fig. 4), the speed of viscosity recovery is very slow. As an evidence thereof, in Fig. 5, considerable amount of time is required for the recovery rate to even reach, for example, 0.90. This slowness in recovery leads to fluctuations in the discharged amount and, eventually, to the problem with dispensing properties.

Meanwhile, in the case of the Examples, viscosity can be recovered quickly, and not only the dispensing properties but also the bonding properties can be made preferable. As can be seen from the results described above, it is preferable that the recovery rate of the bonding material as defined above be high: Specifically, the same at the measurement starting timepoint is preferably higher than or equal to 0.80, more preferably higher than or equal to 0.85.

### [Examples 4 to 7]

In Examples 4 to 7, HINOACT KF-1000 (Example 4), MA-WAX-O (Example 5), Tsunodyme 395 (Example 6), and hydrogenated castor oil (Example 7) were used in place of BYK-R606 used in Examples 1 to 3 as the crosslinking-type inter-particle distance keeping agent, the test was conducted accordingly. The method for producing the first and second fine silver particles are the same as for Example 1, and also for other matters, the same matters as those in Example 1 are adopted unless specifically noted otherwise.

### Production of Bonding Material

Next, what are listed below were kneaded and the substance thus obtained through kneading was passed through a 3-roll machine to obtain a bonding material constituted by a silver paste.
- 14.61% by mass of the dry powder of the fine silver particles (coated with hexanoic acid) with a particle size of 17 nm, produced as the first fine silver particles as described above
- 26.97% by mass of the dry powder of the fine silver particles (coated with sorbic acid) with a particle size of 85 nm, produced as the second fine silver particles as described above
- 51.09% by mass of silver particles (AG2-1C (DOWA Electronics Materials Co., Ltd.)) with a particle size of 0.6 µm
- 1.49% by mass of octanediol (2-ethyl-1,3-hexanediol (Wako Pure Chemical Corporation)) as a first solvent
- 0.80% by mass of 1-dodecanol (Tokyo Chemical Industry Co., Ltd.) as a second solvent
- 3.49% by mass of 2-methyl-butane-1,3,4-triol (isoprene triol B (IPTL-B)) (Nippon Terpene Chemicals, Inc.) as a third solvent
- 0.50% by mass of butoxyethoxy acetic acid (BEA) (Tokyo Chemical Industry Co., Ltd.) as the dispersing agent
- 1.00% by mass of another acid-type dispersing agent
- 0.05% by mass of the crosslinking-type inter-particle distance keeping agent according to Examples 4 to 7

Table 3 below shows the aforementioned constituents and the contents thereof. The constituents and the contents thereof for the examples described below are also shown in Table 3.

**[Table 3]**

| | Example 4 | Example 5 | Example 6 | Example 7 |
|---|---|---|---|---|
| First fine silver particles | 14.61 | 14.61 | 14.61 | 14.61 |
| Second fine silver particles | 26.97 | 26.97 | 26.97 | 26.97 |
| Silver particles: AG2-1C | 51.09 | 51.09 | 51.09 | 51.09 |
| First solvent: 2-ethyl-1,3-hexanediol | 1.49 | 1.49 | 1.49 | 1.49 |
| Second solvent: dodecanol | 0.8 | 0.8 | 0.8 | 0.8 |
| Third solvent: IPTL-B | 3.49 | 3.49 | 3.49 | 3.49 |
| Dispersing Agent: butoxyethoxy acetic acid | 0.5 | 0.5 | 0.5 | 0.5 |
| Other acid-type dispersing agent | 1 | 1 | 1 | 1 |
| Crosslinking-type inter-particle distance keeping agent: HINOACT KF-1000 | 0.05 | 0 | 0 | 0 |
| Crosslinking-type inter-particle distance keeping agent: MA-WAX-O | 0 | 0.05 | 0 | 0 |
| Crosslinking-type inter-particle distance keeping agent: Tsunodyme 395 | 0 | 0 | 0.05 | 0 |
| Crosslinking-type inter-particle distance keeping agent: Hydrogenated castor oil | 0 | 0 | 0 | 0.05 |

### Viscosity of Bonding Material

The viscosity of this bonding material (silver paste) at 25°C was measured with a rheometer (rotary dynamic viscoelasticity measurement device) (HAAKE RheoStress 600 (a cone with a cone diameter of 35 mm and a cone angle of 2° was used) (Thermo Fisher Scientific)). The viscosity and thixotropy (Ti = viscosity (1 rpm)/viscosity (5 rpm)) of each of the above are shown in Table 4 below. The viscosity and Ti for the examples described below are also shown in Table 4.

**[Table 4]**

| | | Example 4 | Example 5 | Example 6 | Example 7 |
|---|---|---|---|---|---|
| Viscosity | 1 rpm | 65.41 | 60.62 | 53.49 | 67.95 |
| | 5 rpm | 26.79 | 26.03 | 25.63 | 27.02 |
| Ti | | 2.44 | 2.33 | 2.09 | 2.51 |

### [Evaluation]

### Evaluation of Dispensing Properties

As stated above, a reason for which the dispensing properties of the bonding material are preferable is that viscosity recovers quickly in the bonding material when shear force ceases to be applied. Accordingly, in Examples 4 to 7, the evaluation of dispensing properties is based on how quickly viscosity recovers. Specifically, the method used in the [Verification of Quick Viscosity Recovery in Examples] section above was adopted to carry out the measurements. Figs. 6 to 13 show results for Examples 4 to 7.

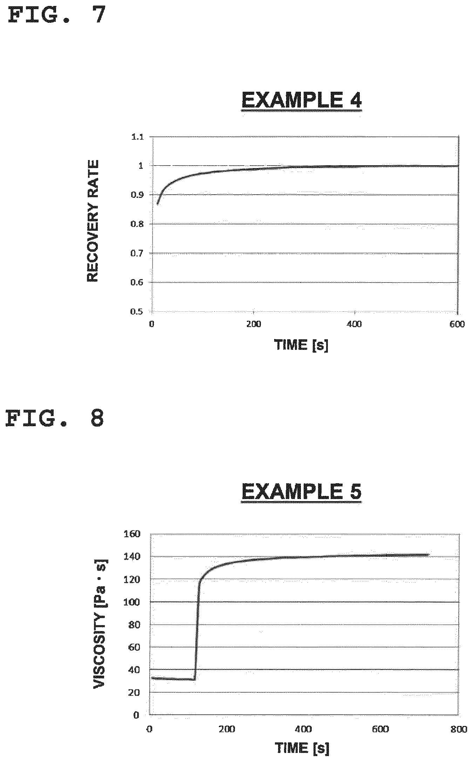

Fig. 6 is a plot showing a result relating to a change over time of viscosity when a shear strength (shear rate: 1/s) was changed for a bonding material according to Example 4 (HINOACT KF-1000), where the horizontal axis indicates time (s) and the vertical axis indicates viscosity (Pa·s). Fig. 7 is a plot showing a result relating to a change over time of a recovery rate obtained on the basis of Fig. 6, where the horizontal axis indicates time (s) and the vertical axis indicates the recovery rate. 0th second in Fig. 7 corresponds to the timepoint of the 120th second in Fig. 6.

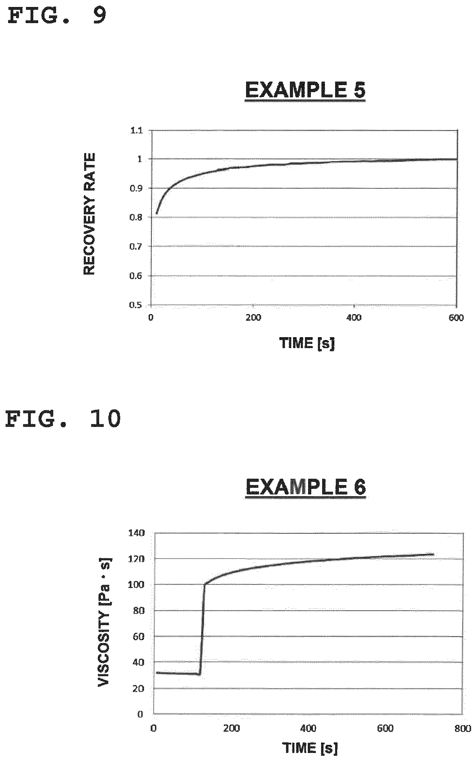

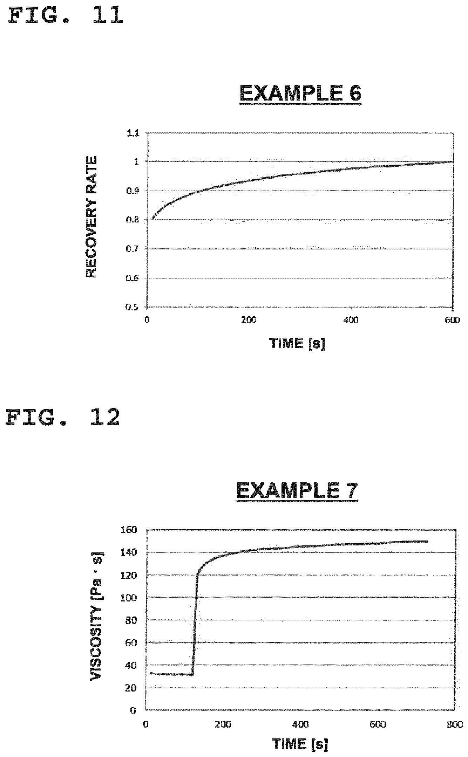

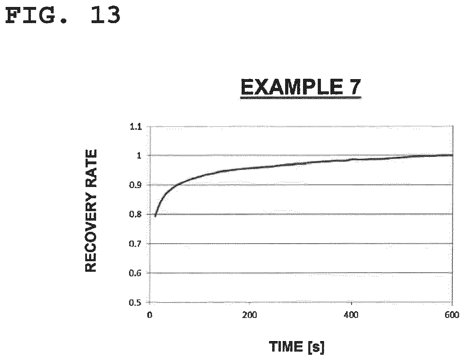

Results for Example 4 correspond to Figs. 6 and 7, and likewise, results for Example 5 (MA-WAX-O) correspond to Figs. 8 and 9, results for Example 6 (Tsunodyme 395) correspond to Figs. 10 and 11, and results for Example 7 (hydrogenated castor oil) correspond to Figs. 12 and 13.

In all these Examples, viscosity recovered quickly after the shear rate was reduced to 1 (1/s) at once, compared to Comparative example 2. As an evidence thereof, in all these Examples, the recovery rate at the measurement starting timepoint is higher than or equal to 0.78. It should be noted that for Examples 6 and 7, as compared to Examples 4 and 5 (and Example 1), viscosity recovery is slower (for example, the time until the viscosity recovery rate reaches 0.95 is longer), and the bonding materials of Examples 4 and 5 are superior in terms of dispensing properties.

In addition, in Example 4 (HINOACT KF-1000) and in Example 5 (MA-WAX-O) in particular among Examples 4 to 7, viscosity recovered quickly.

### Evaluation of Bonding Properties

Next, bonding test was conducted using an equivalent method to Examples 1 to 3 and Comparative examples 1 and 2 above.

From the results of the evaluation of bonding properties, in cases in which the bonding materials of Examples 4 to 7 were used, bonding was favorable, but compared to Examples 1 to 3, a small amount of voids or cracks were observed.

According to the above, a bonding material having both preferable dispensing properties and preferable bonding properties, and a bonding method employing the bonding material, could be provided in the case of examples 4 to 7. The existence of differences between these examples in terms of dispensing properties and the inferiority of these examples compared to examples 1 to 3 in terms of bonding properties are as described above.

### Synopsis

As can be seen from the above results, in the bonding materials in all of the Examples, a crosslinking-type inter-particle distance keeping agent was added and the dispensing properties and bonding properties were preferable.

Meanwhile, Comparative examples 1 and 2 in which no crosslinking-type inter-particle distance keeping agent was added gave either a result with unfavorable dispensing properties in terms of weight fluctuation in the discharged amount in the dispenser exceeding ±10% or a result with unfavorable bonding properties in terms of occurrence of cracks or voids.

## Claims

1. A bonding material comprising
fine silver particles having an average primary particle diameter of smaller than or equal to 130 nm, and
a crosslinking-type inter-particle distance keeping agent crosslinking between the fine silver particles and keeping a distance between the fine silver particles.

2. The bonding material according to claim 1, wherein
the crosslinking-type inter-particle distance keeping agent is a compound α expressed by formula (I) below 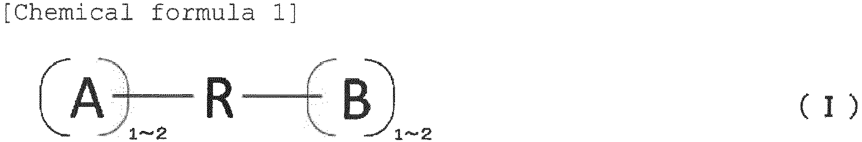 (here, in formula (I), R represents an organic group having a valence of 2 to 4,
A and B represent a hydroxyl group, amino group, carboxyl group, or thiol group, and in a case where two As are present, the two As may be identical or different from each other and in a case where two Bs are present, the two Bs may be identical or different from each other, and
assuming that in the longest straight-chain moiety forming R, the longest moiety from among moieties between an atom 1 bonding to A and an atom 2 bonding to B is a first main chain, the number of chain-forming atoms of the first main chain is 10 to 180).

3. The bonding material according to claim 2, wherein
at least one from among A and B in the formula (I) is a hydroxyl group, amino group, or thiol group, and
the longest straight-chain moiety forming R in the formula (I) has a side chain, and the number of chain-forming atoms of the longest straight-chain moiety in the side chain is smaller than or equal to 1/3 of the number of chain-forming atoms of the first main chain.

4. The bonding material according to claim 2 or 3, wherein the longest straight-chain moiety forming R in the formula (I) has a side chain, the side chain is a hydrocarbon group having a carbon number of 1 to 12, and A and B may bond to the side chain.

5. The bonding material according to any one of claims 2 to 4, wherein
assuming that in the formula (I), the longest straight-chain moiety forming the compound α is a second main chain, chain-forming atoms (excluding atoms at a chain terminal) of the first main chain and the second main chain form a group selected from -CH₂-, -CH(R^{a})-, -C(R^{a})₂-, -CX₂-, -CX(R^{a})-, - CH=, -C(R^{a})=, =C=, -CO-, -NH-, -N(R^{a})-, -N=, -N(OH)-, -O-, - S-, and -SO₂- (here, R^{a} represents a side chain of the longest straight-chain moiety forming R, and X represents halogen).

6. The bonding material according to claim 2, wherein the compound α is any one of formulae (II) to (IV) below 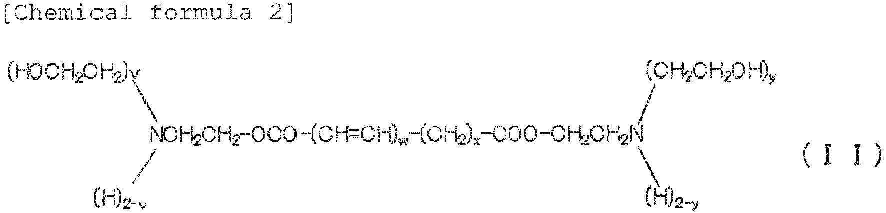 (here, in formula (II), v and y are each independently an integer of 1 to 2, w is an integer of 0 to 10, and x is an integer of 14 to 40) 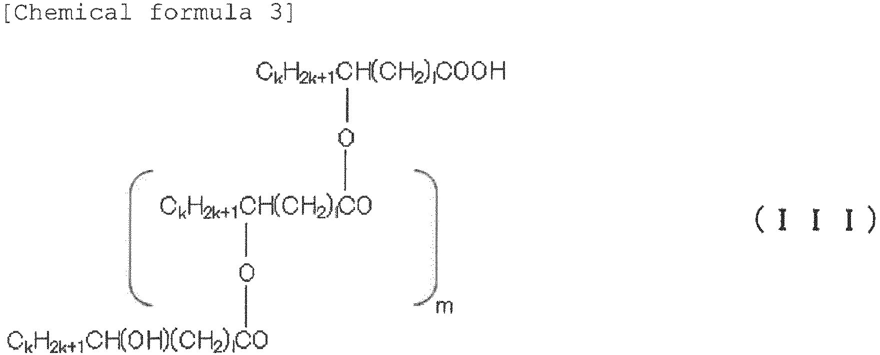 (here, in formula (III), the plurality of ks are each independently an integer of 3 to 10, the plurality of ls are each independently an integer of 6 to 16, and m is an integer of 2 to 8)
[Chemical formula 4]
CₙH₂ₙ₊₁CH(OH)-(CH₂)ₚ-CONH-(CH₂)_{q}-NHCO-(CH₂)ᵣ-CH(OH)CₛH₂ₛ₊₁ (IV)
(here, in formula (IV), n and s are each independently an integer of 3 to 10, p and r are each independently an integer of 6 to 18, and q is an integer of 2 to 10).

7. The bonding material according to any one of claims 1 to 6, wherein
the bonding material further comprises silver particles having an average primary particle diameter of 0.3 to 10 µm.

8. The bonding material according to any one of claims 1 to 7, wherein
the fine silver particles are coated with an organic compound.

9. The bonding material according to any one of claims 1 to 8, wherein
the bonding material further comprises a polar solvent.

10. The bonding material according to any one of claims 1 to 9, wherein
the bonding material further comprises an acid-type dispersing agent.

11. A bonding method comprising:
placing the bonding material according to any one of claims 1 to 10 between substances to be bonded and heating the bonding material to form a bonding layer from the bonding material; and bonding together the substances accordingly.
